Europäisches Patentamt

European Patent Office

Office européen des brevets

(19)

(11) Numéro de publication:　**0 296 019**
**A1**

# (12) DEMANDE DE BREVET EUROPEEN

(21) Numéro de dépôt: **88401374.9**

(51) Int. Cl.⁴: **H 05 K 7/20**

(22) Date de dépôt: **07.06.88**

(30) Priorité: **16.06.87 FR 8708372**

(43) Date de publication de la demande:
**21.12.88　Bulletin　88/51**

(84) Etats contractants désignés:
**DE ES GB IT NL SE**

(71) Demandeur: **THOMSON-CSF**
**173, Boulevard Haussmann**
**F-75379 Paris Cédex 08　(FR)**

(72) Inventeur: **Sauzade, Jean-Denis**
**Thomson-CSF SCPI-19, avenue de Messine**
**F-75008 Paris　(FR)**

**L'Hote, Manuel**
**Thomson-CSF SCPI-19, avenue de Messine**
**F-75008 Paris　(FR)**

(74) Mandataire: **Desperrier, Jean-Louis et al**
**THOMSON-CSF SCPI 19, avenue de Messine**
**F-75008 Paris　(FR)**

(54) **Support pour circuit imprimé formant drain thermique à dilatation contrôlée, et procédé de fabrication.**

(57) L'invention concerne les supports formant drain thermique pour les cartes de circuits imprimés.

Elle consiste à réaliser un tel support avec une âme (208) en graphite orienté par compression pour obtenir une très forte conductivité thermique latérale et une densité relativement faible. Cette âme est maintenue par deux peaux extérieures (206,207) formées de plis de fibres de carbone noyées dans une matrice en résine époxy. Un cadre métallique (210) réalisé en invar vient rigidifier le support.

Elle permet d'obtenir des supports conduisant très bien la chaleur tout en étant légers.

EP 0 296 019 A1

## Description

## SUPPORT POUR CIRCUIT IMPRIME, FORMANT DRAIN THERMIQUE A DILATATION CONTROLEE, ET PROCEDE DE FABRICATION

La présente invention se rapporte aux supports qui permettent de maintenir les circuits imprimés formant des cartes électroniques, plus particulièrement celles du type dites micro-assemblées, tout en évacuant la chaleur dégagée au niveau de ces cartes et en limitant les déformations dues à l'augmentation de température. Elle concerne également les procédés de fabrication de ces supports.

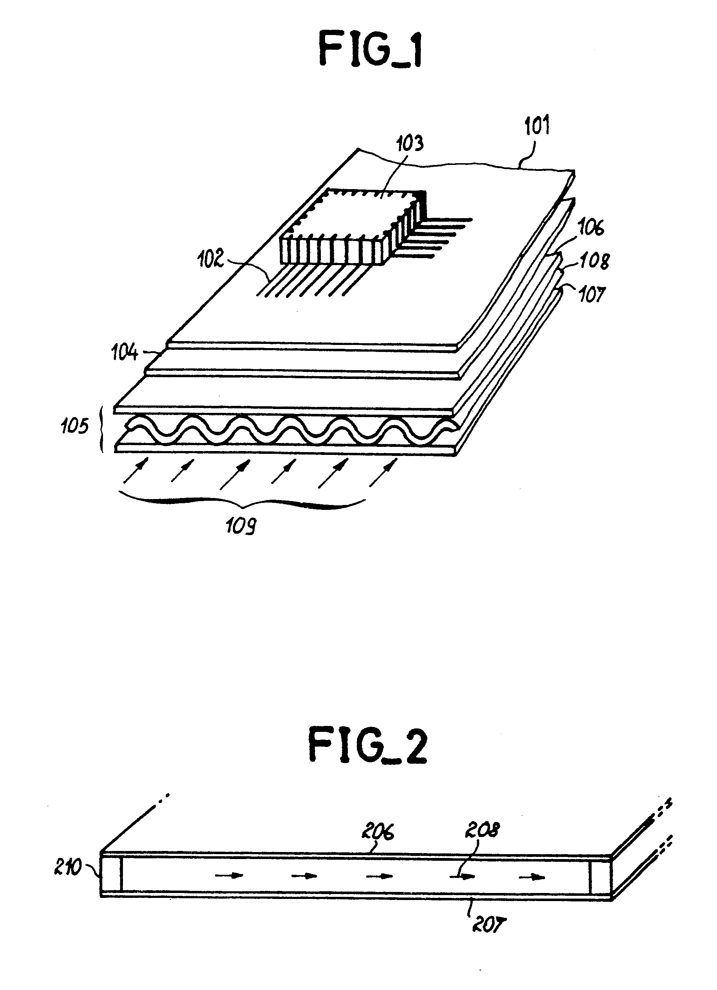

Il est connu de fabriquer des cartes électroniques dites micro-assemblées, telles que représentées par exemple sur la figure 1, en fixant sur une plaquette 101 de circuit imprimé, comportant des interconnexions telles que 102, des composants, par exemple des circuits intégrés à semi-conducteurs, encapsulés dans des boîtiers en céramique tels que 103 connus sous le terme anglo-saxon de "Chip Carrier". Ces composants ne comportent pas de broches de sortie mais seulement des bornes affleurant la surface du boîtier et fixées rigidement sur celui-ci. Ces bornes ne permettent pas d'absorber les contraintes thermiques dues à la dilation, tant du boîtier que du circuit imprimé, sous l'effet de la chaleur dégagée dans le composant, comme c'est le cas pour les broches, dites "pattes", des circuits intégrés classiques, encapsulés dans du plastique par exemple.

Le coefficient de dilation de la céramique utilisée pour ces boîtiers (6 à 7 PPM/°C) est inférieur à celui des matériaux traditionnels, tels que le verre époxy, utilisé pour la réalisation des circuits imprimés (13 à 16 PPM/°C). De ce fait on obtient un différentiel de dilation lors de la montée en température, et au bout d'un certain nombre de cycles on observe, au niveau des soudures ou des brasures reliant les bornes des boîtiers aux pistes du circuit imprimé, l'apparition de fissures, ce qui altère la fiabilité de l'assemblage.

Pour pallier cet inconvénient, on ajuste dans l'art connu le coefficient de dilatation du circuit imprimé à celui de la céramique en le fixant rigidement, par exemple par collage à l'aide d'une couche adhésive 104, sur un support 105 dont le coefficient de dilatation est faible et très proche de celui de la céramique, et le module de Young, important de façon à contraindre le circuit 101 en résistant à son excès de dilatation par rapport à celui des boîtiers 103. Ces supports sont généralement appelés stabilisateurs dimensionnels. Dans le cas où la carte micro-assemblée dissipe une grande quantité de chaleur, on aménage également le support pour pouvoir évacuer un maximum de calories.

Une première solution pour fabriquer un tel support consiste à réaliser une structure métallique, appelée aussi colaminé. La plus connue de ces structures comprend une couche d'invar prise en sandwich entre deux couches de cuivre. L'invar, comme on le sait, est un alliage de fer à 36% de nickel dont le coefficient de dilation est très faible et proche de 0. Comme le cuivre présente un coefficient de dilation sensiblement égal à 17 PPM/°C, en ajustant les épaisseurs de cuivre et d'invar on peut obtenir le coefficient de dilatation souhaité. Les épaisseurs de cuivre à utiliser sont relativement importantes, ce qui permet d'obtenir de surcroît une bonne conductivité thermique. Les résultats sont satisfaisants, mais pour obtenir une conductivité thermique importante, supérieure par exemple à 150 W/°Cxm, on obtient une structure assez lourde.

Une solution pour diminuer ce poids, représentée sur la figure 1, consiste à utiliser deux feuilles de colaminés cuivre invar 106 et 107 planes prenant en sandwich une autre feuille de colaminé 108 ondulée. Ceci permet de faire circuler un fluide de refroidissement 109 dans le vide existant entre la couche centrale et les couches externes, et de profiter du surcroît de refroidissement ainsi obtenu pour diminuer l'épaisseur de ces trois couches.

On peut utiliser d'autres alliages de ferro-nickel que l'invar, ou également du mobyldène.

Un autre procédé pour réaliser ces supports consiste à utiliser des matériaux composites à faible coefficient de dilatation, constitués par exemple de fibre de polyimide telle que celle connue sous la marque déposée "Kevlar", ou des fibres de quartz, noyées dans une matrice en résine époxy ou en polyimide. Ces matériaux ont un module de Young élevé, mais sont de très mauvais conducteurs thermiques. En outre leur mise en oeuvre n'est pas encore très bien maîtrisée. On connaît cependant un matériau composite, le carbone/carbone, qui outre sonmodule de Young élevé et sa légèreté, est également un bon conducteur thermique. Toutefois ce matériau est très cher et il est difficile de se le procurer, ce qui réserve son usage à des cas très particuliers, tels que les satellites.

Pour pallier ces inconvénients, l'invention propose de réaliser un tel support en utilisant une couche centrale formée de feuilles de graphite fortement comprimées pour obtenir une conductivité thermique latérale très importante avec une faible densité. Cette couche étant relativement fragile on la prend en sandwich entre deux couches plus minces à fort module et très faible coefficient de dilatation, composées de nappes stratifiées de fibres de carbone noyées dans un liant tel que de la résine époxy. Pour compléter la tenue mécanique de l'ensemble on maintient cet ensemble dans un cadre métallique présentant une faible dilatation.

D'autres particularités et avantages de l'invention apparaîtront clairement dans la description suivante, présentée à titre d'exemple non limitatif en regard des figures annexées qui représentent :

    - la figure 1 : une vue en perspective d'un support selon l'art antérieur ;

    - la figure 2 : une coupe d'un support selon l'invention ; et

    - les figures 3 et 4 : des courbes caractéristiques du matériau utilisé pour l'invention.

On a représenté sur la figure 2 un support selon l'invention vu en perspective et en coupe correspondant au support 105 de la figure 1.

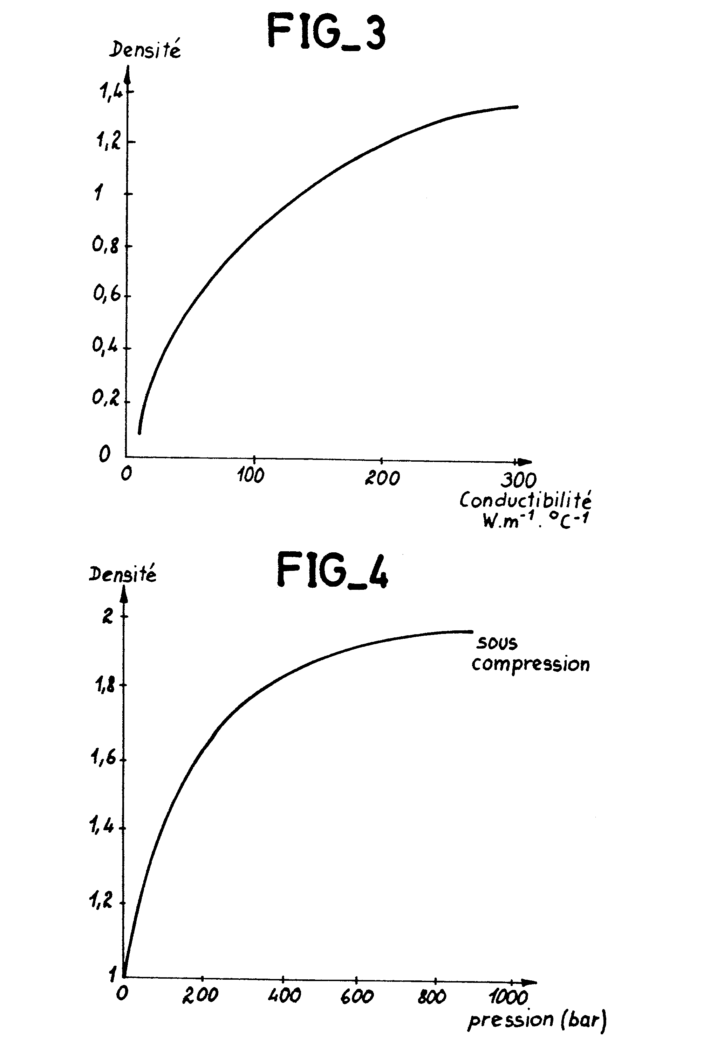

Ce support comprend essentiellement une âme 208 formée à partir de feuilles de graphite, elles-mêmes constituées de particules fortement orientées dans le plan de la feuille. On peut en particulier se procurer de telles feuilles auprès de la Société "LE CARBONE-LORRAINE" qui les commercialise sous la marque déposée "PAPYEX". Ces feuilles forment un matériau très anisotrope à de multiples points de vue, et dans l'invention on utilise essentiellement la propriété d'anisotropie thermique latérale. En effet la conductivité thermique latérale, c'est-à-dire dans le plan de la feuille, croît très rapidement avec la densité, en particulier lorsque cette densité varie entre 1 et 1,4, de sorte que la conductivité est élevée même pour des densités faibles. La loi de variation de cette conductivité, exprimée en W/mx°C est représentée sur la figure 3. Pour obtenir cette variation de densité, entraînant la variation de conductibilité, il suffit de presser les feuilles de graphite, par exemple entre les plateaux d'une presse, sous des pressions de quelques centaines de bars. La variation de la densité en fonction de la pression, exprimée en bars, est représentée sur la figure 4.

En rapprochant les graphiques des figures 3 et 4, on constate qu'à partir d'une densité supérieure à 1,2, correspondant à une pression tout à fait modérée de 40 bars, on obtient une conductibilité thermique supérieure à 200 W/mx°C. Cette conductibilité est tout à fait satisfaisante dans la plupart des cas rencontrés dans la pratique, et la densité correspondante du matériau est remarquablement faible si on la compare à celle de l'invar.

Le coefficient de dilatation de ce matériau est quasiment nul, mais comme il est malheureusement assez fragile on le prend en sandwich entre deux couches, ou peaux, 206 et 207, suffisamment rigides et solides pour contraindre la plaque de circuit imprimé qui sera collée sur elles.

Pour cela on fabrique ces peaux à l'aide de fibres de carbone disposées jointivement et liées au moyen d'une résine époxy formant une matrice. Ces fibres sont disposées sous la forme d'au moins deux couches, dites "plis", croisées entre elles pour assurer l'anisotropie de la résistance aux contraintes. Le plus généralement ces couches sont croisées à 90° les unes par rapport aux autres, et leur orientation par rapport aux bords du support peut prendre diverses valeurs. L'une des valeurs les plus courantes consiste à mettre un pli à 0° et un pli à 90°, c'est-à-dire le premier parallèle au grand côté du support et le second perpendiculaire à celui-ci. Une variante procurant une meilleure anisotropie consiste à utiliser une orientation +45°/-45°. Ces plis sont disponibles sur le marché sous une forme préimprégnée de résine époxy prête à l'emploi, et dite carbone-époxy haute température.

La conductibilité thermique des peaux ainsi réalisées est relativement moyenne, mais cette technique permet, avec des peaux d'une épaisseur comprise entre 100 et 300 μm, d'obtenir un module de Young supérieur à 100 GPa, ce qui est généralement suffisant dans les usages habituels dans lesquels l'épaisseur de l'âme est comprise entre 0,5 et 2mm. Cette faible épaisseur permet ainsi d'avoir une conductibilité thermique de l'ensemble suffisante.

On pourrait éventuellement améliorer la conductivité thermique des plis formant la peau en utilisant des fibres de carbone cuivrées ou nickelées.

Pour obtenir un support ayant un dimensionnement bien précis et des bords résistant aux chocs éventuels, on utilise un cadre 210, qui vient border tout le pourtour de l'âme et sur lequel sont fixées les peaux. Il faut bien entendu que ce cadre ait une bonne conductivité thermique, et pour cela on peut par exemple utiliser un alliage de cuivre et d'invar pour former ce cadre.

Un procédé pour réaliser un support selon l'invention comporte par exemple les étapes suivantes :
- on réalise tout d'abord le cadre 210 par des procédés d'assemblage mécaniques tout à fait ordinaires ;
- on fabrique ensuite l'âme en empilant à l'intérieur de ce cadre une quantité suffisante de feuilles de graphite, par exemple du type PAPYEX, et l'on soumet l'ensemble à une pression de plusieurs centaines de bars, par exemple 600 bars, pour obtenir l'écrasement souhaité du graphite. L'épaisseur initiale de l'empilement de feuilles est prévue pour que, lorsque la pression désirée est appliquée, les plateaux de la presse viennent s'arrêter au niveau du cadre et que l'âme ainsi comprimée vienne affleurer le cadre ;
- on découpe ensuite les plis aux dimensions extérieures du cadre et on vient les placer sur celui-ci en les croisant selon l'orientation souhaitée, puis on soumet l'ensemble à une pression de quelques bars, par exemple 7 bars, à une température relativement modérée, par exemple 175°C ;
- dans une dernière étape on polymérise totalement la résine époxy qui imprègne les plis en passant l'ensemble à l'étuve pendant quelques heures, 4 heures par exemple, à une température légèrement supérieure à celle de l'étape précédente, par exemple 190°C.

En utilisant les valeurs de température et de pression données pour exemple ci-dessus, on obtient un support qui présente un coefficient de dilatation compris entre 0 et 3 PPM/°C, une conductivité thermique latérale entre 200 et 300 W/mx°C, une densité comprise entre 1,5 et 3 et un module de Young compris entre 120 et 200 10⁹Pa.

## Revendications

1. Support pour circuit imprimé, formant drain thermique à dilatation contrôlée, caractérisé en ce qu'il comprend :
- une couche centrale (208) en graphite orientée par compression pour présenter simultanément une conductivité thermique latérale importante et une densité faible ; et
- deux couches extérieures (206,207) en fibres de carbone noyées dans une matrice en résine, présentant un grand module de Young et prenant en sandwich la couche centrale.

2. Support selon la revendication 1, caractérisé en ce qu'il comprend en outre un cadre métallique (210) entourant la couche centrale (208) pour rigidifier le support ; ce cadre étant réalisé en un alliage à faible dilatation.

3. Support selon l'une quelconque des revendications 1 et 2, caractérisé en ce que la couche centrale (208) est faite de feuilles de graphite comprimées.

4. Support selon l'une quelconque des revendications 1 à 3, caractérisé en ce que la couche centrale (208) présente une conductivité thermique latérale supérieure à 200 W/mx°C et une densité inférieure à 1,4.

5. Support selon l'une quelconque des revendications 1 à 4, caractérisé en ce que les couches extérieures (206,207) sont formées de plusieurs plis de fibres parallèles croisés entre eux.

6. Support selon la revendication 5, caractérisé en ce que lesdits plis sont orientés successivement à 0 et à 90° par rapport aux bords du support.

7. Support selon la revendication 5, caractérisé en ce que les plis sont orientés sucessivement à -45° et à + 45° par rapport aux bords dudit support.

8. Support selon l'une quelconque des revendications 1 à 7, caractérisé en ce que la résine imprégnant les plis est une résine époxy.

9. Support selon l'une quelconque des revendications 1 à 8, caractérisé en ce que les fibres formant les couches extérieures (206,207) sont revêtues d'un matériau conducteur de la chaleur tel que le cuivre ou le nickel.

10. Support selon l'une quelconque des revendications 2 à 9, caractérisé en ce que le cadre métallique (210) est formé d'un alliage cuivre/invar.

11. Procédé de fabrication d'un support selon l'une quelconque des revendications 1 à 10, caractérisé en ce que l'on empile une série de feuilles en graphite et qu'on les écrase sous une pression de l'ordre de plusieurs centaines de bars.

# FIG_1

# FIG_2

# FIG_3

Densité

Conductibilité
W.m$^{-1}$.°C$^{-1}$

# FIG_4

Densité

sous
compression

pression (bar)

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A-1 114 066  (THE TRANE CO.) <br> * Page 1, lignes 69-84 * <br> --- | 1 | H 05 K   7/20 |
| A | EP-A-0 197 817  (SOCAPEX) <br> * Page 2, lignes 11-31 * <br> --- | 1 | |
| A | FR-A-2 207 401  (COMPAGNIE INTERNATIONALE POUR L'INFORMATIQUE) <br> * Page 3, lignes 3-18 * <br> ----- | 1 | |

**DOMAINES TECHNIQUES RECHERCHES (Int. Cl.4)**

H 05 K

Le présent rapport a été établi pour toutes les revendications

| Lieu de la recherche | Date d'achèvement de la recherche | Examinateur |
|---|---|---|
| LA HAYE | 04-08-1988 | TOUSSAINT F.M.A. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
...................................................................
& : membre de la même famille, document correspondant

EPO FORM 1503 03.82 (P0402)